# EUROPEAN PATENT APPLICATION

(11) **EP 4 803 936 A1**
(43) Date of publication of application: **09.09.2026**
(21) Application number: 26161894.6
(22) Date of filing: 03.03.2026
(51) Int. Cl.: G01T 1/24

(54) **DETECTOR AND ANALYZER**

(30) Priority: 05.03.2025 JP 2025034580
(71) Applicant: Jeol Ltd., Akishima, Tokyo 196-8558 (JP)
(72) Inventor: TSUBAKI, Shinki, Tokyo, 196-8558 (JP)
(74) Representative: Boult Wade Tennant LLP

(57) **Abstract**

A detector (100) includes: a detecting element (10) that detects X-rays; a cooling element (50) that cools the detecting element (10); and a first shield (30) and a second shield (40) that are disposed between the detecting element (10) and the cooling element (50), wherein the first shield (30) is mainly composed of an element having an atomic number smaller than an average atomic number of materials constituting the second shield (40), a first surface of the first shield (30) and a second surface of the second shield (40) are in contact with each other, and the first surface and the second surface are not fastened to each other.

## Description

### BACKGROUND OF THE INVENTION

### Field of the Invention

The present invention relates to a detector and an analyzer.

### Description of Related Art

Energy-dispersive X-ray spectrometers (EDS) are known as X-ray detectors to be mounted on a scanning electron microscope (SEM), a transmission electron microscope (TEM), a scanning transmission electron Microscope (STEM), a fluorescence X-ray spectrometer (XRF) and the like. An energy-dispersive X-ray spectrometer may be, for example, a silicon drift detector (SDD).

JP 2010-169659 A discloses a detector including an X-ray detecting element, an electrode terminal plate including a connection terminal for electrically connecting the X-ray detecting element to an external circuit, a Peltier element for cooling the X-ray detecting element, and a first shield and a second shield that are arranged between the X-ray detecting element and the Peltier element.

The detector disclosed in JP 2010-169659 A reduces the influence of X-rays secondarily generated when X-rays having passed through the X-ray detecting element excite the components of the Peltier element, by using the first shield mainly composed of an element having an atomic number smaller than the average atomic number of materials constituting the Peltier element, and the second shield mainly composed of an element having an atomic number larger than the average atomic number of materials constituting the Peltier element.

As described above, since the first shield and the second shield are made of different materials, the first shield and the second shield have different thermal expansion coefficients. Therefore, when the X-ray detecting element is cooled by using the Peltier element, the second shield may warp due to a difference in thermal expansion coefficient between the first shield and the second shield, which may cause damage to the Peltier element.

### SUMMARY OF THE INVENTION

According to a first aspect of the present disclosure, there is provided a detector including:
a detecting element that detects X-rays;
a cooling element that cools the detecting element; and
a first shield and a second shield that are disposed between the detecting element and the cooling element, wherein
the first shield is mainly composed of an element having an atomic number smaller than an average atomic number of materials constituting the second shield,
a first surface of the first shield and a second surface of the second shield are in contact with each other, and
the first surface and the second surface are not fastened to each other.

According to a second aspect of the present disclosure, there is provided a detector including:
a detecting element that detects X-rays;
a cooling element that cools the detecting element; and
a first shield and a second shield that are disposed between the detecting element and the cooling element, wherein
the first shield is mainly composed of an element having an atomic number smaller than an average atomic number of materials constituting the second shield,
the second shield is mainly composed of an element having an atomic number larger than an average atomic number of materials constituting the cooling element,
a first surface of the first shield and a second surface of the second shield are joined to each other with a joining member, and
in a region where the first surface and the second surface overlap each other, an area of a joining region in which the first surface and the second surface are joined to each other with the joining member is smaller than an area of a non-joining region where the first surface and the second surface are not joined to each other.

According to a third aspect of the present disclosure, there is provided an analyzer including any of the above-described detectors.

### BRIEF DESCRIPTION OF THE DRAWINGS

FIG. 1 is a perspective view schematically illustrating a detector according to the first embodiment.
FIG. 2 is a cross-sectional view schematically illustrating a detector according to the first embodiment.
FIG. 3 is a plan view schematically illustrating a back side of a second shield.
FIG. 4 is a partially enlarged view of a plan view schematically illustrating a back side of a second shield.
FIG. 5 is a cross-sectional view schematically illustrating a first shield and a second shield.
FIG. 6 is a plan view schematically illustrating a detector according to the second embodiment.
FIG. 7 is a plan view schematically illustrating a back side of a second shield.
FIG. 8 is a cross-sectional view schematically illustrating a principal part of a detector according to the second embodiment.
FIG. 9 is a plan view schematically illustrating a detector according to the third embodiment.
FIG. 10 is a plan view schematically illustrating a back side of a second shield.
FIG. 11 is a cross-sectional view schematically illustrating a principal part of a detector according to the third embodiment.
FIG. 12 is a cross-sectional view schematically illustrating a detector according to the fourth embodiment.
FIG. 13 is a plan view schematically illustrating a back side of a second shield.
FIG. 14 is a cross-sectional view schematically illustrating a principal part of a detector according to the fourth embodiment.
FIG. 15 is a plan view schematically illustrating a modification example of a detector according to the fourth embodiment.
FIG. 16 is a plan view schematically illustrating a modification example of a detector according to the fourth embodiment.
FIG. 17 is a plan view schematically illustrating a modification example of a detector according to the fourth embodiment.
FIG. 18 illustrates an example of a configuration of an electron microscope according to the fifth embodiment.

### DESCRIPTION OF THE INVENTION

According to one embodiment of the present disclosure, there is provided a detector including:
a detecting element that detects X-rays;
a cooling element that cools the detecting element; and
a first shield and a second shield that are disposed between the detecting element and the cooling element, wherein
the first shield is mainly composed of an element having an atomic number smaller than an average atomic number of materials constituting the second shield,
a first surface of the first shield and a second surface of the second shield are in contact with each other, and
the first surface and the second surface are not fastened to each other.

In such a detector, when the detecting element is cooled by using the cooling element, warp of the second shield can be reduced, the warp being caused by the difference in thermal expansion coefficient between the first shield and the second shield. Therefore, in such a detector, the stress generated in the cooling element due to the warp of the second shield can be reduced, thereby reducing the possibility of damage to the cooling element.

According to one embodiment of the present disclosure, there is provided a detector including:
a detecting element that detects X-rays;
a cooling element that cools the detecting element; and
a first shield and a second shield that are disposed between the detecting element and the cooling element, wherein
the first shield is mainly composed of an element having an atomic number smaller than an average atomic number of materials constituting the second shield,
the second shield is mainly composed of an element having an atomic number larger than an average atomic number of materials constituting the cooling element,
a first surface of the first shield and a second surface of the second shield are joined to each other with a joining member, and
in a region where the first surface and the second surface overlap each other, an area of a joining region in which the first surface and the second surface are joined to each other with the joining member is smaller than an area of a non-joining region where the first surface and the second surface are not joined to each other.

In such a detector, when the detecting element is cooled by using the cooling element, warp of the second shield can be reduced, the warp being caused by the difference in thermal expansion coefficient between the first shield and the second shield. Therefore, in such a detector, the stress generated in the cooling element due to the warp of the second shield can be reduced, thereby reducing the possibility of damage to the cooling element.

According to one embodiment of the present disclosure, there is provided an analyzer including any of the above-described detectors.

Preferred embodiments of the invention will be described in detail below with reference to the drawings. It is noted that the following embodiments do not unduly limit the contents of the invention described in the claims. In addition, all of the components described below are not necessarily essential requirements of the invention.

### 1. First Embodiment

### 1.1. Detector

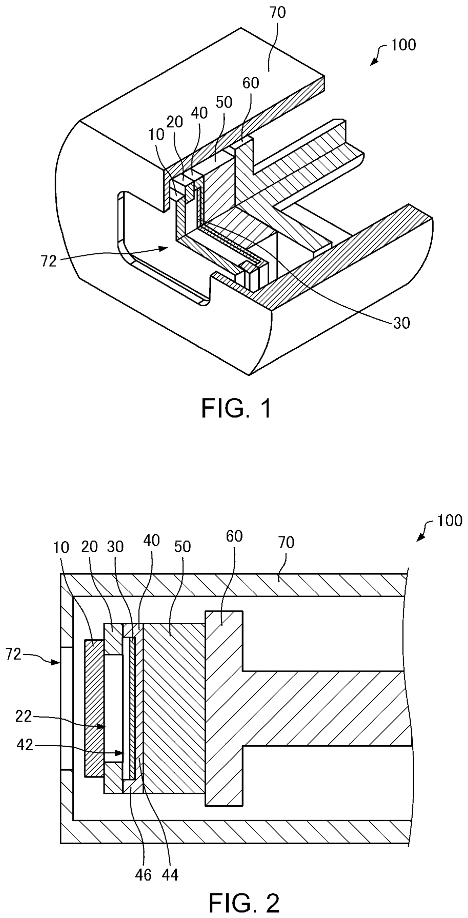

First, a detector according to the first embodiment will be described with reference to the drawings. FIG. 1 is a perspective view schematically illustrating a detector 100 according to the first embodiment. FIG. 2 is a cross-sectional view schematically illustrating the detector 100.

As illustrated in FIGS. 1 and 2, the detector 100 includes a detecting element 10, an electrode terminal plate 20, a first shield 30, a second shield 40, a cooling element 50, a thermal conductor 60, and a housing 70.

The detector 100 detects X-rays. The detector 100 is an energy-dispersive X-ray spectrometer (EDS).

The detecting element 10 is an X-ray detector composed of a solid semiconductor. The detecting element 10 is, for example, a silicon drift detector (SDD). The silicon drift detector is a detector provided with a disc-shaped cathode, an annular electrode, and a collection electrode (anode) in a silicon single crystal. In the silicon drift detector, electronic signals can be processed at higher speed and the counting rate can be improved as compared with a Si(Li) detector.

The electrode terminal plate 20 is disposed between the detecting element 10 and the second shield 40. The electrode terminal plate 20 includes a connection terminal and an electric wiring for electrically connecting the detecting element 10 to an external circuit (not shown). The electrode terminal plate 20 has a frame-like shape. The electrode terminal plate 20 has an opening 22 passing through the electrode terminal plate 20. The opening 22 communicates with a recessed portion 42 of the second shield 40. The material of the electrode terminal plate 20 is, for example, aluminum oxide.

The second shield 40 is disposed between the detecting element 10 and the cooling element 50. The second shield 40 is disposed between the electrode terminal plate 20 and the cooling element 50. The second shield 40 is mainly composed of, for example, an element having an atomic number larger than the average atomic number of materials constituting the first shield 30. For example, the material of the second shield 40 is copper, molybdenum, tungsten, tantalum, gold, or a compound thereof. Alternatively, the second shield 40 may have a laminated structure of these materials.

The second shield 40 attenuates secondary X-rays generated from the cooling element 50 irradiated with X-rays having passed through the detecting element 10. This can reduce the amount of secondary X-rays incident on the detecting element 10. Since the second shield 40 is mainly composed of an element having an atomic number larger than the average atomic number of materials constituting the first shield 30, secondary X-rays generated from the cooling element 50 can be attenuated efficiently. Furthermore, the second shield 40 attenuates secondary X-rays generated from the thermal conductor 60 irradiated with X-rays having passed through the detecting element 10. This can reduce the amount of secondary X-rays incident on the detecting element 10. Since the second shield 40 is mainly composed of an element having an atomic number larger than the average atomic number of materials constituting the first shield 30, secondary X-rays generated from the thermal conductor 60 can be attenuated efficiently.

The second shield 40 has the recessed portion 42. The second shield 40 has a bottom portion 44 and a wall portion 46, and the recessed portion 42 is defined by the bottom portion 44 and the wall portion 46. The bottom portion 44 defines the bottom of the recessed portion 42. The bottom portion 44 is so thick as to reduce the amount of secondary X-rays incident on the detecting element 10. The thickness of the bottom portion 44 is, for example, 0.4 mm or more and 1.0 mm or less. With this configuration, the amount of secondary X-rays incident on the detecting element 10 can be sufficiently reduced. The wall portion 46 defines the inner surface (side) of the recessed portion 42. The first shield 30 is stored in the recessed portion 42. The electrode terminal plate 20 is joined onto the wall portion 46.

The first shield 30 is disposed between the detecting element 10 and the cooling element 50. The first shield 30 is disposed between the detecting element 10 and the second shield 40. In a plan view, the first shield 30 overlaps the opening 22 of the electrode terminal plate 20. The first shield 30 is stored in the recessed portion 42. For example, the first shield 30 is a plate-like member. The thickness of the first shield 30 is, for example, 0.1 mm or more and 0.5 mm or less.

The first shield 30 is mainly composed of an element having an atomic number smaller than the average atomic number of materials constituting the second shield 40. For example, the material of the first shield 30 is carbon, aluminum, beryllium, titanium, or a compound thereof. The first shield 30 may have a laminated structure of these materials.

The first shield 30 attenuates X-rays originating from X-rays transmitted through the detecting element 10 and generated from the second shield 40. This can reduce the amount of secondary X-rays incident on the detecting element 10. For example, in the detector 100, the second shield 40 reduces X-rays generated from the cooling element 50 by irradiation of the cooling element 50 with X-rays transmitted through the detecting element 10. At this time, X-rays generated from the second shield 40 can be reduced by the first shield 30. Furthermore, for example, in the detector 100, the second shield 40 reduces X-rays generated from the thermal conductor 60 by irradiation of the thermal conductor 60 with X-rays transmitted through the detecting element 10. At this time, X-rays generated from the second shield 40 can be reduced by the first shield 30. This can reduce the amount of X-rays generated from the second shield 40.

Since the first shield 30 is mainly composed of an element having an atomic number smaller than the average atomic number of materials constituting the second shield 40, the X-ray excitation efficiency is lower than that of the second shield 40. Therefore, a small amount of secondary X-rays is excited from the first shield 30 by X-rays generated from the second shield 40. Furthermore, a small amount of secondary X-rays is generated from the first shield 30 by irradiation of the first shield 30 with X-rays transmitted through the detecting element 10. Therefore, the amount of secondary X-rays incident on the detecting element 10 can be reduced by the first shield 30.

The cooling element 50 is disposed between the second shield 40 and the thermal conductor 60. The cooling element 50 is joined to the second shield 40. The cooling element 50 cools the detecting element 10. The cooling element 50 is thermally connected to the detecting element 10 through the second shield 40 and the electrode terminal plate 20. Therefore, the detecting element 10 can be cooled by the cooling element 50.

The cooling element 50 is, for example, a Peltier element. A Peltier element is a cooling element using the Peltier effect, a phenomenon in which heat is generated or absorbed at a contact point when a current is applied to joined different metals. Materials that make up the Peltier element include, for example, heavy metals such as bismuth, tellurium, and indium.

The thermal conductor 60 transmits heat emitted from the cooling element 50. Heat emitted from the cooling element 50 is released through the thermal conductor 60.

The housing 70 accommodates the detecting element 10, the electrode terminal plate 20, the first shield 30, the second shield 40, the cooling element 50, and the thermal conductor 60. The housing 70 has a window portion 72 that allows passage of X-rays. X-rays having passed through the window portion 72 are detected by the detecting element 10. The window portion 72 is an opening formed in the housing 70. The window portion 72 may have a transmitting film that allows passage of X-rays and includes a thin film composed of a polymer or an inorganic material.

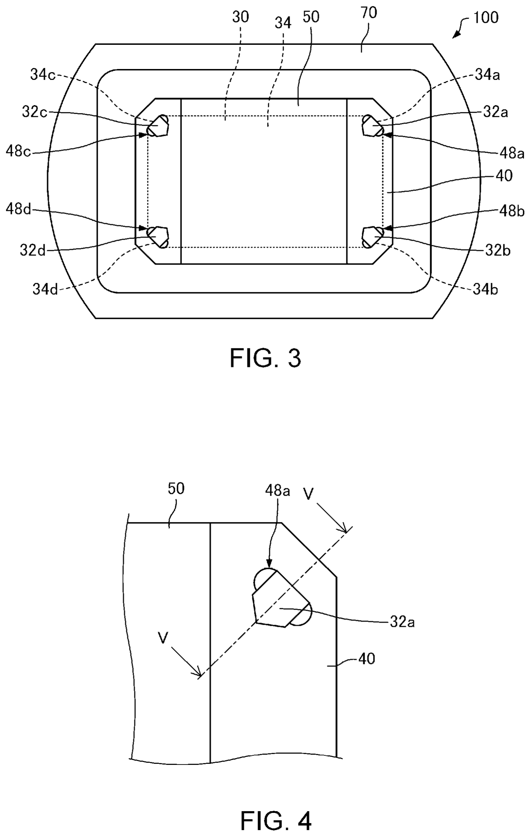

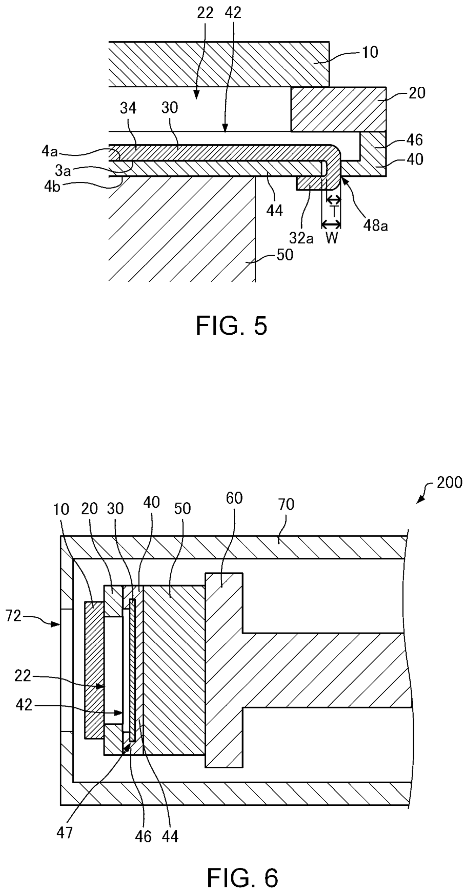

FIG. 3 is a plan view schematically illustrating the back side of the second shield 40. FIG. 4 is a partially enlarged view of a plan view schematically illustrating the back side of the second shield 40. FIG. 5 is a cross-sectional view schematically illustrating the first shield 30 and the second shield 40. Note that FIG. 5 is a cross-sectional view taken along line V-V of FIG. 4.

As illustrated in FIG. 5, a lower surface 3a (an example of a first surface) of the first shield 30 is in contact with a bottom surface 4a (an example of a second surface) of the recessed portion 42 of the second shield 40. The lower surface 3a of the first shield 30 and the bottom surface 4a of the second shield 40 are not fastened to each other. That is, the lower surface 3a of the first shield 30 and the bottom surface 4a of the second shield 40 are not joined to each other. For example, the lower surface 3a of the first shield 30 and the bottom surface 4a of the second shield 40 are not joined to each other at any point with an adhesive or the like. The cooling element 50 is joined to a lower surface 4b (an example of a third surface) of the second shield 40. The lower surface 4b of the second shield 40 is on a reverse side of the bottom surface 4a of the recessed portion 42.

As illustrated in FIG. 3, the second shield 40 has a first through-hole 48a, a second through-hole 48b, a third through-hole 48c, and a fourth through-hole 48d. As illustrated in FIG. 5, one opening of the first through-hole 48a is provided in the bottom surface 4a of the second shield 40, and the other opening of the first through-hole 48a is provided in the lower surface 4b of the second shield 40. The same applies to the second through-hole 48b, the third through-hole 48c, and the fourth through-hole 48d.

The first shield 30 includes a first claw portion 32a, a second claw portion 32b, a third claw portion 32c, a fourth claw portion 32d, and a substrate 34. For example, the substrate 34 is shaped like a plate that is rectangular in plan view. The substrate 34 has four corners (a first corner 34a, a second corner 34b, a third corner 34c, and a fourth corner 34d).

The first claw portion 32a is provided at the first corner 34a of the substrate 34. The first claw portion 32a is a portion projecting from the substrate 34. The first claw portion 32a is inserted into the first through-hole 48a (an example of a first engaging portion) of the second shield 40. The first claw portion 32a is bent at the first through-hole 48a. Since the first claw portion 32a is bent, the first claw portion 32a is caught on the second shield 40. The first claw portion 32a is folded back through the first through-hole 48a. In this way, the first claw portion 32a is engaged with the first through-hole 48a. As illustrated in FIG. 5, a width W of the first through-hole 48a is larger than a thickness T of the first shield 30.

The tip of the first claw portion 32a and the lower surface 4b of the second shield 40 may be joined to each other. The tip of a first claw portion 32a and the lower surface 4b of the second shield 40 may be bonded to each other with, for example, an adhesive.

The second claw portion 32b is provided at the second corner 34b of the substrate 34. The second claw portion 32b is inserted into the second through-hole 48b (an example of a second engaging portion) of the second shield 40. The configuration of the second claw portion 32b is identical to that of the first claw portion 32a, and the configuration of the second through-hole 48b is identical to that of the first through-hole 48a.

The third claw portion 32c is provided at the third corner 34c of the substrate 34. The third claw portion 32c is inserted into the third through-hole 48c (an example of a third engaging portion) of the second shield 40. The configuration of the third claw portion 32c is identical to that of the first claw portion 32a, and the configuration of the third through-hole 48c is identical to that of the first through-hole 48a.

The fourth claw portion 32d is provided at the fourth corner 34d of the substrate 34. The fourth claw portion 32d is inserted into the fourth through-hole 48d (an example of a fourth engaging portion) of the second shield 40. The configuration of the fourth claw portion 32d is identical to that of the first claw portion 32a, and the configuration of the fourth through-hole 48d is identical to that of the first through-hole 48a.

The first shield 30 can be fixed to the second shield 40 by grasping the second shield 40 with the first claw portion 32a, the second claw portion 32b, the third claw portion 32c, and the fourth claw portion 32d. Thus, the first shield 30 is fixed to the second shield 40 with the first claw portion 32a, the second claw portion 32b, the third claw portion 32c, and the fourth claw portion 32d without joining the lower surface 3a of the first shield 30 and the bottom surface 4a of the second shield 40, so that the lower surface 3a of the first shield 30 and the bottom surface 4a of the second shield 40 are not fastened to each other. Therefore, when the detecting element 10 is cooled by using the cooling element 50, warp of the second shield 40 can be reduced, the warp being caused by a difference in thermal expansion coefficient between the first shield 30 and the second shield 40.

The width W of the first through-hole 48a is larger than the thickness T of the first shield 30. That is, in the first through-hole 48a, a gap is provided between a surface of the second shield 40 defining the first through-hole 48a and the first shield 30 (lower surface 3a). In this configuration, the thermal expansion coefficient of the first shield 30 is larger than that of the second shield 40. Therefore, when the detecting element 10 is cooled by using the cooling element 50, the first shield 30 shrinks more than the second shield 40. The width W of the first through-hole 48a is larger than the thickness T of the first shield 30, thereby reducing warp of the second shield 40, the warp being caused by the difference in shrinkage amount between the first shield 30 and the second shield 40.

The difference in thermal expansion coefficient between the electrode terminal plate 20 and the second shield 40 is smaller than the difference in thermal expansion coefficient between the first shield 30 and the second shield 40. Therefore, when the detecting element 10 is cooled by using the cooling element 50, deformation occurring in the electrode terminal plate 20 and the second shield 40 can be reduced, the deformation being caused by the difference in thermal expansion coefficient between the electrode terminal plate 20 and the second shield 40.

The difference in thermal expansion coefficient between the cooling element 50 and the second shield 40 is smaller than the difference in thermal expansion coefficient between the first shield 30 and the second shield 40. Therefore, when the detecting element 10 is cooled by using the cooling element 50, deformation occurring in the cooling element 50 and the second shield 40 can be reduced, the deformation being caused by the difference in thermal expansion coefficient between the cooling element 50 and the second shield 40.

### 1.2. Method for Manufacturing Detector

Next, a method for manufacturing the detector 100 will be described below.

As illustrated in FIGS. 3 to 5, the first shield 30 is fixed to the second shield 40. Specifically, the first claw portion 32a of the first shield 30 is inserted into the first through-hole 48a of the second shield 40, and the first claw portion 32a is bent. Similarly, the second claw portion 32b is inserted into the second through-hole 48b, and the second claw portion 32b is bent. Likewise, the third claw portion 32c is inserted into the third through-hole 48c, and the third claw portion 32c is bent. Similarly, the fourth claw portion 32d is inserted into the fourth through-hole 48d, and the fourth claw portion 32d is bent. Thus, the first shield 30 can be fixed to the second shield 40 without fastening the lower surface 3a of the first shield 30 and the bottom surface 4a of the recessed portion 42 of the second shield 40 to each other.

Since the first shield 30 is fixed to the second shield 40 with the first claw portion 32a, the second claw portion 32b, the third claw portion 32c, and the fourth claw portion 32d, the first shield 30 can be fixed to the second shield 40 without using a joining member such as an adhesive, thereby improving the working efficiency.

As illustrated in FIGS. 2 and 5, the cooling element 50 is joined to the lower surface 4b of the second shield 40. The cooling element 50 and the second shield 40 are joined to each other with, for example, an adhesive.

As illustrated in FIGS. 2 and 5, the electrode terminal plate 20 with the attached detecting element 10 is joined to the wall portion 46 of the second shield 40. The electrode terminal plate 20 and the wall portion 46 are joined to each other with, for example, an adhesive.

As illustrated in FIG. 2, the thermal conductor 60 is joined to the cooling element 50. The cooling element 50 and the thermal conductor 60 are joined to each other with, for example, an adhesive.

As the adhesive for joining the cooling element 50 and the second shield 40, for example, an epoxy adhesive or an acrylic adhesive can be used. It is preferable to use an adhesive that does not emit gas components in a vacuum. The adhesive for joining the electrode terminal plate 20 and the second shield 40 and the adhesive for joining the cooling element 50 and the thermal conductor 60 may also be the same as the adhesive for joining the cooling element 50 and the second shield 40.

As illustrated in FIGS. 1 and 2, the detecting element 10, the electrode terminal plate 20, and the first shield 30, the second shield 40, the cooling element 50, and the thermal conductor 60 are stored in the housing 70.

The detector 100 can be manufactured through the above-mentioned process. The order of steps for manufacturing the detector 100 is not particularly limited.

### 1.3. Effects

The detector 100 includes the detecting element 10 for detecting X-rays, the cooling element 50 for cooling the detecting element 10, and the first shield 30 and the second shield 40 that are disposed between the detecting element 10 and the cooling element 50. The first shield 30 is mainly composed of an element having an atomic number smaller than the average atomic number of materials constituting the second shield 40. The lower surface 3a of the first shield 30 and the bottom surface 4a of the second shield 40 are in contact with each other, and the lower surface 3a and the bottom surface 4a are not fastened to each other. Therefore, when the detecting element 10 is cooled by using the cooling element 50 in the detector 100, warp of the second shield 40 can be reduced, the warp being caused by a difference in thermal expansion coefficient between the first shield 30 and the second shield 40. Thus, in the detector 100, the stress generated in the cooling element 50 due to the warp of the second shield 40 can be reduced, thereby reducing the possibility of damage to the cooling element 50.

For example, when the detecting element 10 is increased in size to capture more X-rays, the areas of the first shield 30 and the second shield 40 are also increased. Therefore, for example, when the lower surface 3a of the first shield 30 and the bottom surface 4a of the second shield 40 are fastened to each other with a joining member or the like, warp of the second shield 40 is increased, the warp being caused by a difference in thermal expansion coefficient between the first shield 30 and the second shield 40. As described above, in the detector 100, warp of the second shield 40 can be reduced, the warp being caused by the difference in thermal expansion coefficient between the first shield 30 and the second shield 40. Thus, even when the detecting element 10 is increased in size, the possibility of damage to the cooling element 50 can be reduced.

In the detector 100, the first shield 30 has the first claw portion 32a, whereas the second shield 40 has the first through-hole 48a serving as the first engaging portion that is in engagement with the first claw portion 32a. Thus, in the detector 100, the first shield 30 can be fixed to the second shield 40 without fastening the lower surface 3a of the first shield 30 and the bottom surface 4a of the second shield 40 to each other.

In the detector 100, the first claw portion 32a is inserted into the first through-hole 48a and is bent at the first through-hole 48a. Thus, in the detector 100, the second shield 40 can be gripped by the first claw portion 32a.

In the detector 100, the first shield 30 has the second claw portion 32b, whereas the second shield 40 has the second through-hole 48b serving as the second engaging portion that is in engagement with the second claw portion 32b. Thus, in the detector 100, the second shield 40 can be gripped by the first claw portion 32a and the second claw portion 32b.

In the detector 100, the first shield 30 has the third claw portion 32c and the fourth claw portion 32d, whereas the second shield 40 has the third through-hole 48c serving as the third engaging portion that is in engagement with the third claw portion 32c, and the fourth through-hole 48d serving as the fourth engaging portion that is in engagement with the fourth claw portion 32d. Furthermore, the first claw portion 32a is provided at the first corner 34a of the first shield 30, the second claw portion 32b is provided at the second corner 34b of the first shield 30, the third claw portion 32c is provided at the third corner 34c of the first shield 30, and the fourth claw portion 32d is provided at the fourth corner 34d of the first shield 30. Thus, in the detector 100, the second shield 40 can be gripped by the four claw portions provided at the four corners of the first shield 30.

In the detector 100, the second shield 40 has the recessed portion 42, and the first shield 30 is disposed in the recessed portion 42. Thus, in the detector 100, the first shield 30 can be prevented from coming into contact with the detecting element 10.

The detector 100 includes the electrode terminal plate 20 having a connection terminal for electrically connecting the detecting element 10 and an external circuit, the second shield 40 includes the wall portion 46 defining the recessed portion 42, and the electrode terminal plate 20 is joined to the wall portion 46. Furthermore, the second shield 40 has the lower surface 4b that is on a reverse side of the bottom surface 4a, and the cooling element 50 is joined to the lower surface 4b. When the detecting element 10 is cooled by using the cooling element 50 in the detector 100, warp of the second shield 40 can be reduced, the warp being caused by a difference in thermal expansion coefficient between the first shield 30 and the second shield 40. This can reduce the possibility of damage to the cooling element 50 joined to the lower surface 4b of the second shield 40.

In the detector 100, the difference in thermal expansion coefficient between the electrode terminal plate 20 and the second shield 40 is smaller than the difference in thermal expansion coefficient between the first shield 30 and the second shield 40. Therefore, in the detector 100, deformation of the electrode terminal plate 20 and the second shield 40 can be reduced, the deformation being caused by the difference in thermal expansion coefficient between the electrode terminal plate 20 and the second shield 40.

In the detector 100, the difference in thermal expansion coefficient between the cooling element 50 and the second shield 40 is smaller than the difference in thermal expansion coefficient between the first shield 30 and the second shield 40. Therefore, in the detector 100, deformation of the cooling element 50 and the second shield 40 can be reduced, the deformation being caused by the difference in thermal expansion coefficient between the cooling element 50 and the second shield 40.

### 2. Second Embodiment

### 2.1. Detector

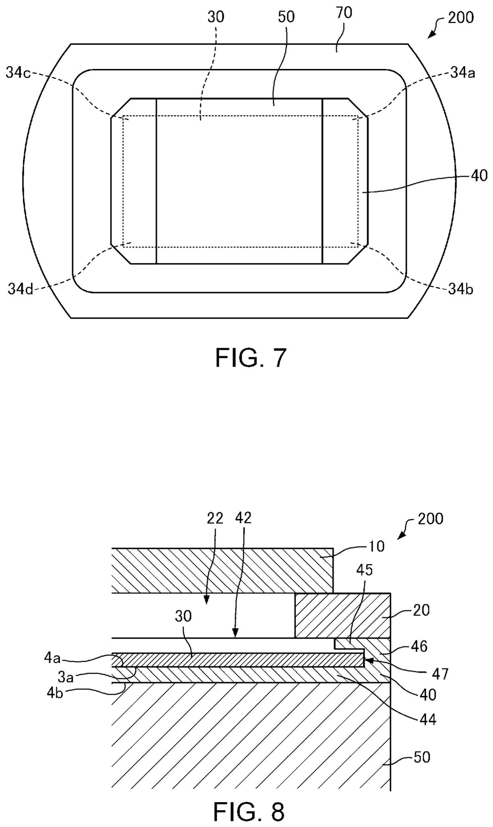

Next, a detector according to the second embodiment will be described with reference to the drawings. FIG. 6 is a plan view schematically illustrating a detector 200 according to the second embodiment. FIG. 7 is a plan view schematically illustrating the back side of a second shield 40. FIG. 8 is a cross-sectional view schematically illustrating the principal part of the detector 200. Hereinafter, in the detector 200 according to the second embodiment, members having functions similar to those of the components of the detector 100 according to the first embodiment are denoted by the same reference numerals, and detailed descriptions thereof are omitted.

In the detector 200, as illustrated in FIGS. 6 to 8, a groove 47 is provided on a wall portion 46 defining a recessed portion 42 of the second shield 40. A first shield 30 is inserted into the groove 47. By inserting the first shield 30 into the groove 47, the first shield 30 can be fixed to the second shield 40 without fastening a lower surface 3a of the first shield 30 and a bottom surface 4a of the recessed portion 42 of the second shield 40 to each other.

A projecting portion 45 that projects toward the center of the recessed portion 42 is provided at one end of the wall portion 46. The first shield 30 is inserted between the projecting portion 45 and a bottom portion 44. For example, the groove 47 surrounds the entire outer edge of the first shield 30. That is, all of the four sides of the first shield 30 that is rectangular in plan view may be inserted into the groove 47. In addition, for example, two opposing sides of the four sides of the first shield 30 that is rectangular in plan view may be inserted into the groove 47.

### 2.2. Method for Manufacturing Detector

A method for manufacturing the detector 200 is the same as the method for manufacturing the detector 100 described above, except that the first shield 30 is fixed to the second shield 40 by inserting the first shield 30 into the groove 47 provided on the wall portion 46 of the second shield 40. The description thereof is omitted.

### 2.3. Effects

In the detector 200, the second shield 40 includes the bottom portion 44 and the wall portion 46 that define the recessed portion 42, the groove 47 is provided on the wall portion 46, and the first shield 30 is inserted into the groove 47. Thus, in the detector 200, the first shield 30 can be fixed to the second shield 40 without fastening the lower surface 3a of the first shield 30 and the bottom surface 4a of the recessed portion 42 of the second shield 40 to each other. Therefore, in the detector 200, when a detecting element 10 is cooled by using a cooling element 50, warp of the second shield 40 can be reduced, the warp being caused by a difference in thermal expansion coefficient between the first shield 30 and the second shield 40. As a result, in the detector 200, the possibility of damage to the cooling element 50 can be reduced.

### 3. Third Embodiment

### 3.1. Detector

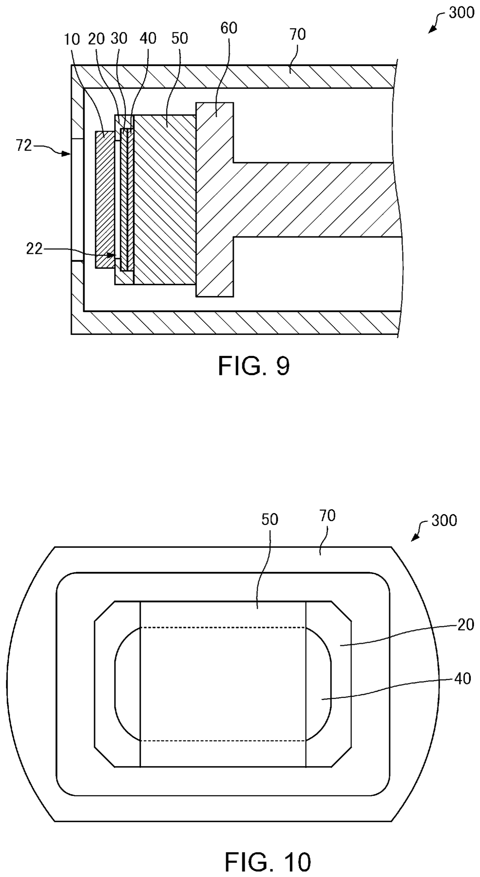

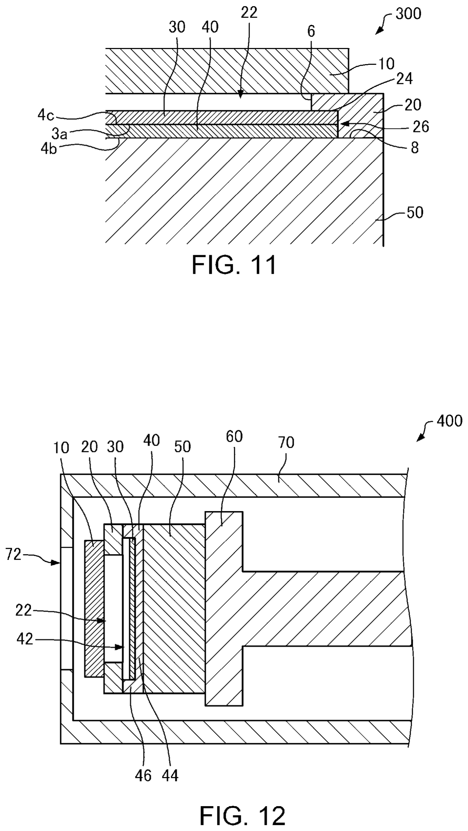

Next, a detector according to the third embodiment will be described with reference to the drawings. FIG. 9 is a plan view schematically illustrating a detector 300 according to the third embodiment. FIG. 10 is a plan view schematically illustrating the back side of a second shield 40. FIG. 11 is a cross-sectional view schematically illustrating the principal part of the detector 300. Hereinafter, in the detector 300 according to the third embodiment, members having functions similar to those of the components of the detector 100 according to the first embodiment are denoted by the same reference numerals, and detailed descriptions thereof are omitted.

In the detector 300, an electrode terminal plate 20 has a step 24, and a first shield 30 and the second shield 40 are inserted into a groove 26 formed by the step 24. By inserting the first shield 30 and the second shield 40 into the groove 26 formed by the step 24, the first shield 30 can be fixed to the second shield 40 without fastening a lower surface 3a of the first shield 30 and an upper surface 4c of the second shield 40 to each other.

The electrode terminal plate 20 has a frame-like shape with an opening 22. The step 24 is provided on an inner surface 6 of the electrode terminal plate 20. The inner surface 6 of the electrode terminal plate 20 defines the opening 22.

In the detector 300, the electrode terminal plate 20 and a cooling element 50 are joined to each other. The groove 26 is formed by the electrode terminal plate 20 and the cooling element 50. The groove 26 is defined by the step 24 of the electrode terminal plate 20 and a joint surface 8 of the cooling element 50. The joint surface 8 of the cooling element 50 is a surface to which the electrode terminal plate 20 is joined. The electrode terminal plate 20 and the cooling element 50 are joined to each other with, for example, an adhesive.

The difference in thermal expansion coefficient between the electrode terminal plate 20 and the cooling element 50 is smaller than the difference in thermal expansion coefficient between the first shield 30 and the second shield 40. Therefore, deformation of the cooling element 50 can be reduced, the deformation being caused by the difference in thermal expansion coefficient between the electrode terminal plate 20 and the cooling element 50. This can reduce the possibility of damage to the cooling element 50.

For example, the first shield 30 is a plate-like member. For example, the second shield 40 is a plate-like member. The second shield 40 has the upper surface 4c and a lower surface 4b that is on a reverse side of the upper surface 4c. The first shield 30 and the second shield 40 are stacked on top of each other. The lower surface 3a of the first shield 30 and the upper surface 4c of the second shield 40 are in contact with each other. In a plan view, for example, the first shield 30 and the second shield 40 are identical in shape. The thickness of the first shield 30 may be equal to or different from the thickness of the second shield 40. The lower surface 4b of the second shield 40 is joined to the joint surface 8 of the cooling element 50 with a joining member such as an adhesive.

### 3.2. Method for Manufacturing Detector

A method for manufacturing the detector 300 is the same as the method for manufacturing the detector 100 described above, except that the first shield 30 is fixed to the second shield 40 by inserting the first shield 30 and the second shield 40 into the groove 26 and the electrode terminal plate 20 is joined to the cooling element 50. The description thereof is omitted.

### 3.3. Effects

In the detector 300, the electrode terminal plate 20 has the step 24, and the first shield 30 and the second shield 40 are inserted into the groove 26 formed by the step 24. Thus, in the detector 300, the first shield 30 can be fixed to the second shield 40 without fastening the lower surface 3a of the first shield 30 and the bottom surface 4a of the recessed portion 42 of the second shield 40 to each other. Therefore, in the detector 300, when a detecting element 10 is cooled by using the cooling element 50, warp of the second shield 40 can be reduced, the warp being caused by a difference in thermal expansion coefficient between the first shield 30 and the second shield 40. As a result, in the detector 300, the possibility of damage to the cooling element 50 can be reduced.

### 4. Fourth Embodiment

### 4.1. Detector

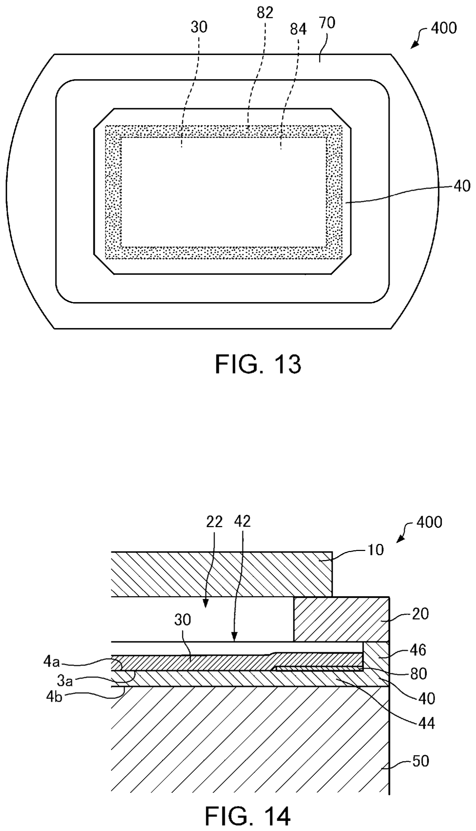

Next, a detector according to the fourth embodiment will be described with reference to the drawings. FIG. 12 is a cross-sectional view schematically illustrating a detector 400 according to the fourth embodiment. FIG. 13 is a plan view schematically illustrating the back side of a second shield 40. FIG. 14 is a cross-sectional view schematically illustrating the principal part of the detector 400. Hereinafter, in the detector 400 according to the fourth embodiment, members having functions similar to those of the components of the detector 100 according to the first embodiment are denoted by the same reference numerals, and detailed descriptions thereof are omitted.

In the above-described detector 100, the lower surface 3a of the first shield 30 and the bottom surface 4a of the second shield 40 are not bound or joined to each other. In contrast, in the detector 400, a lower surface 3a of a first shield 30 and a bottom surface 4a of the second shield 40 are joined to each other with a joining member 80 as illustrated in FIGS. 13 and 14. In the region where the lower surface 3a and the bottom surface 4a overlap each other, the area of a joining region 82 where the lower surface 3a and the bottom surface 4a are joined to each other with the joining member 80 is smaller than the area of a non-joining region 84 where the lower surface 3a and the bottom surface 4a are not joined to each other.

Thus, when a detecting element 10 is cooled by using a cooling element 50 in the detector 400, warp of the second shield 40 can be reduced, the warp being caused by a difference in thermal expansion coefficient between the first shield 30 and the second shield 40, as compared with the case in which the area of the joining region 82 is equal to or larger than the area of the non-joining region 84.

As illustrated in FIG. 13, the joining region 82 is provided along the outer edge of the first shield 30. The joining region 82 is shaped like a frame surrounding the non-joining region 84.

The joining member 80 is, for example, an adhesive. The adhesive used as the joining member 80 may be, for example, an epoxy adhesive or an acrylic adhesive. The adhesive used as the joining member 80 preferably emits no gaseous components in a vacuum.

### 4.2. Method for Manufacturing Detector

A method for manufacturing the detector 400 is the same as the method for manufacturing the detector 100 described above, except that the first shield 30 and the second shield 40 are fixed with the joining member 80. The description thereof is omitted.

### 4.3. Effects

In the detector 400, the lower surface 3a (an example of a first surface) of the first shield 30 and the bottom surface 4a (an example of a second surface) of the recessed portion 42 of the second shield 40 are joined to each other with the joining member 80. In the region where the lower surface 3a and the bottom surface 4a overlap each other, the area of the joining region 82 where the lower surface 3a and the bottom surface 4a are joined to each other with the joining member 80 is smaller than the area of the non-joining region 84 where the lower surface 3a and the bottom surface 4a are not joined to each other. Thus, when a detecting element 10 is cooled by using a cooling element 50 in the detector 400, warp of the second shield 40 can be reduced, the warp being caused by a difference in thermal expansion coefficient between the first shield 30 and the second shield 40, as compared with the case in which the area of the joining region 82 is equal to or larger than the area of the non-joining region 84. Thus, in the detector 400, the possibility of damage to the cooling element 50 can be reduced.

### 4.4. Modifications

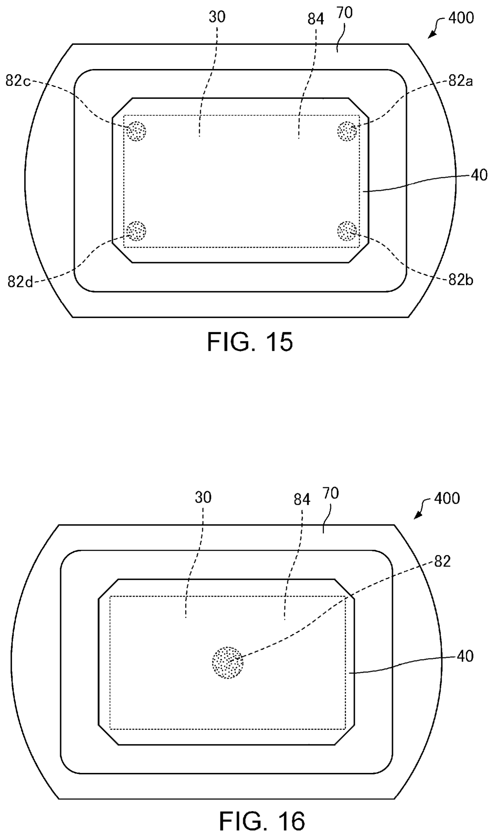

FIG. 15 is a plan view schematically illustrating a modification example of the detector 400.

As illustrated in FIG. 15, the joining region 82 may include a first portion 82a, a second portion 82b, a third portion 82c, and a fourth portion 82d. The first portion 82a, the second portion 82b, the third portion 82c, and the fourth portion 82d are arranged at the respective four corners of the first shield 30.

FIG. 16 is a plan view schematically illustrating a modification example of the detector 400.

As illustrated in FIG. 16, the joining region 82 may be provided at the center of the first shield 30.

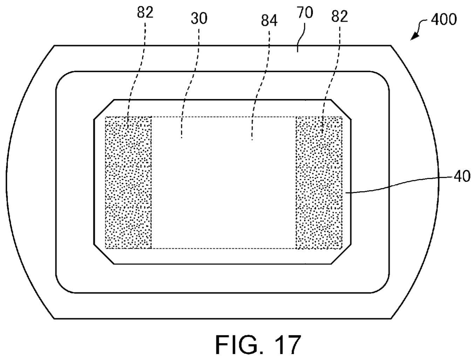

FIG. 17 is a plan view schematically illustrating a modification example of the detector 400.

As illustrated in FIG. 17, the joining regions 82 may be provided along two opposite sides of the first shield 30 that is rectangular in plan view.

As illustrated in FIGS. 15 to 17, the shape, position, and area of the joining region 82 are not particularly limited if the area of the joining region 82 is smaller than the area of the non-joining region 84.

### 5. Fifth Embodiment

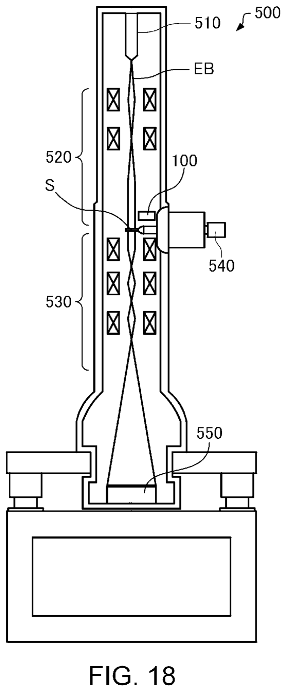

Next, an electron microscope according to the fifth embodiment will be described with reference to the drawings. FIG. 18 illustrates an example of the configuration of an electron microscope 500 according to the fifth embodiment.

A detector 100 is mounted in the electron microscope 500. Therefore, in the electron microscope 500, X-rays emitted from a specimen S can be analyzed by energy-dispersive X-ray spectroscopy.

The electron microscope 500 includes an electron gun 510, an irradiation system 520 for irradiating the specimen S with an electron beam EB, an imaging system 530 for forming an image of the specimen using the electron beam EB having passed through the specimen S, a specimen holder 540 for holding the specimen S, and an imaging device 550 for capturing a specimen image formed by the imaging system 530.

The electron microscope 500 is a transmission electron microscope in which an electron beam EB from the electron gun 510 is emitted to the specimen S using the irradiation system 520, and the imaging system 530 is used to form a specimen image with the electron beam EB having passed through the specimen S. In the electron microscope 500, X-rays emitted from the specimen S by irradiating the specimen S with electron beams can be detected by the detector 100.

Since the electron microscope 500 includes the detector 100, the possibility of damage to the cooling element 50 can be reduced when the detecting element 10 is cooled by using the cooling element 50. In the above description, the electron microscope 500 includes the detector 100. The electron microscope 500 may include the detector 200, the detector 300, or the detector 400.

Note that the present invention is not limited to the above-described embodiments, and various modifications can be made within the scope of the present invention.

For example, in the fifth embodiment described above, an analyzer according to one embodiment of the present disclosure is a transmission electron microscope, but an analyzer according to one embodiment of the present disclosure is not limited to a transmission electron microscope if the analyzer includes a detector according to one embodiment of the present disclosure. For example, an analyzer according to one embodiment of the present disclosure may be an apparatus that irradiates a specimen with ion beams or X-rays. For example, an analyzer according to one embodiment of the present disclosure may be, for example, a scanning transmission electron microscope (STEM), a scanning electron microscope (SEM), an electron probe microanalyzer (EPMA), a focused ion-beam apparatus (FIB), or an X-ray fluorescence analyzer (XRF).

The invention is not limited to the above-described embodiments, and various modifications can be made. For example, the invention includes configurations that are substantially the same as the configurations described in the embodiments. Substantially same configurations mean configurations having the same functions or methods, for example. The invention also includes configurations obtained by replacing non-essential elements of the configurations described in the embodiments with other elements. The invention further includes configurations obtained by adding known art to the configurations described in the embodiments.

## Claims

1. A detector comprising:
a detecting element that detects X-rays;
a cooling element that cools the detecting element; and
a first shield and a second shield that are disposed between the detecting element and the cooling element, wherein
the first shield is mainly composed of an element having an atomic number smaller than an average atomic number of materials constituting the second shield,
a first surface of the first shield and a second surface of the second shield are in contact with each other, and
the first surface and the second surface are not fastened to each other.

2. The detector according to claim 1, wherein
the first shield includes a first claw portion, and
the second shield includes a first engaging portion that is in engagement with the first claw portion.

3. The detector according to claim 2, wherein
the first engaging portion is a first through-hole passing through the second shield.

4. The detector according to claim 3, wherein
the first claw portion is inserted into the first through-hole and is bent at the first through-hole.

5. The detector according to claim 2 or 3, wherein
the first shield includes a second claw portion, and
the second shield includes a second engaging portion that is in engagement with the second claw portion.

6. The detector according to claim 5, wherein
the first shield includes a third claw portion and a fourth claw portion,
the second shield includes a third engaging portion that is in engagement with the third claw portion, and a fourth engaging portion that is in engagement with the fourth claw portion,
the first claw portion is provided at a first corner of the first shield,
the second claw portion is provided at a second corner of the first shield,
the third claw portion is provided at a third corner of the first shield, and
the fourth claw portion is provided at a fourth corner of the first shield.

7. The detector according to any one of claims 1 to 6, wherein
the second shield includes a recessed portion with the second surface serving as a bottom surface, and
the first shield is disposed in the recessed portion.

8. The detector according to claim 7, further comprising
a terminal plate including a connection terminal for electrically connecting the detecting element and an external circuit, wherein
the second shield includes a wall portion defining the recessed portion,
the terminal plate is joined to the wall portion,
the second shield includes a third surface on a reverse side of the second surface, and
the cooling element is joined to the third surface.

9. The detector according to claim 1, wherein
the second shield includes a bottom portion and a wall portion that define a recessed portion,
the wall portion has a groove, and
the first shield is inserted into the groove.

10. The detector according to claim 1, further comprising
a terminal plate including a connection terminal for electrically connecting the detecting element and an external circuit, wherein
the terminal plate has a step, and
the first shield and the second shield are inserted into a groove formed by the step.

11. The detector according to any one of claims 1 to 10, further comprising
a terminal plate including a connection terminal for electrically connecting the detecting element and an external circuit,
wherein a difference in thermal expansion coefficient between the terminal plate and the second shield is smaller than a difference in thermal expansion coefficient between the first shield and the second shield.

12. The detector according to any one of claims 1 to 11, wherein
the cooling element is joined to the second shield, and
a difference in thermal expansion coefficient between the cooling element and the second shield is smaller than a difference in thermal expansion coefficient between the first shield and the second shield.

13. A detector comprising:
a detecting element that detects X-rays;
a cooling element that cools the detecting element; and
a first shield and a second shield that are disposed between the detecting element and the cooling element, wherein
the first shield is mainly composed of an element having an atomic number smaller than an average atomic number of materials constituting the second shield,
the second shield is mainly composed of an element having an atomic number larger than an average atomic number of materials constituting the cooling element,
a first surface of the first shield and a second surface of the second shield are joined to each other with a joining member, and
in a region where the first surface and the second surface overlap each other, an area of a joining region in which the first surface and the second surface are joined to each other with the joining member is smaller than an area of a non-joining region where the first surface and the second surface are not joined to each other.

14. The detector according to claim 13, wherein
the joining region includes a first portion and a second portion separated from each other.

15. An analyzer comprising the detector according to any one of claims 1 to 14.
